# FASCICULE DE BREVET EUROPEEN

(11) **EP 3 900 052 B1**
(45) Date de publication et mention de la délivrance du brevet: **12.10.2022**
(21) Numéro de dépôt: 19832376.8
(22) Date de dépôt: 20.12.2019
(51) Int. Cl.: H01L 31/18

(54) **PROCÉDÉ DE PASSIVATION DE CELLULES PHOTOVOLTAÏQUES ET PROCÉDÉ DE FABRICATION DE SOUS-CELLULES PHOTOVOLTAÏQUES PASSIVÉES**
VERFAHREN ZUR PASSIVIERUNG VON FOTOVOLTAISCHEN ZELLEN UND VERFAHREN ZUR HERSTELLUNG PASSIVIERTER FOTOVOLTAISCHER UNTERZELLEN
PROCESS FOR PASSIVATING PHOTOVOLTAIC CELLS AND PROCESS FOR PRODUCING PASSIVATED PHOTOVOLTAIC SUB-CELLS

(30) Priorité: 21.12.2018 FR 1874013
(43) Date de publication de la demande: 27.10.2021
(73) Titulaire: Commissariat à l'Energie Atomique et aux Energies Alternatives, 75015 Paris (FR); Centre national de la recherche scientifique, 75016 Paris (FR); Institut Polytechnique de Grenoble, 38000 Grenoble (FR)
(72) Inventeur: GERENTON, Felix, 38054 GRENOBLE CEDEX 09 (FR); NGUYEN, Viet Huong, 38100 GRENOBLE (FR); MUNOZ-ROJAS, David, 38000 GRENOBLE (FR); HARRISON, Samuel, 38054 GRENOBLE CEDEX 09 (FR); MUNOZ, Maria-Delfina, 38054 GRENOBLE CEDEX 09 (FR)
(74) Mandataire: Cabinet Camus Lebkiri
(86) Numéro de dépôt international: PCT/EP2019/086561
(87) Numéro de publication internationale: WO 2020/127896

(56) Documents cités:
- EP-A1- 3 139 416
- WO-A2-2012/057823
- FR-A1- 3 060 852
- US-A1- 2015 249 173
- FLORIAN WERNER ET AL: "High-rate atomic layer deposition of Al2O3 for the surface passivation of Si solar cells", ENERGY PROCEDIA, vol. 8, avril 2011 (2011-04), pages 301-306, XP028263082, ISSN: 1876-6102, DOI: 10.1016/J.EGYPRO.2011.06.140 [extrait le 2011-08-12]

## Description

### DOMAINE TECHNIQUE

La présente invention est relative à la fabrication de cellules photovoltaïques. L'invention concerne plus particulièrement un procédé de passivation des surfaces latérales de cellules photovoltaïques entières ou de morceaux de cellules découpés dans des cellules photovoltaïques entières.

### ÉTAT DE LA TECHNIQUE

Un module photovoltaïque comprend une multitude de cellules photovoltaïques identiques connectées en série et/ou en parallèle afin de fournir en sortie la tension et/ou le courant requis pour alimenter des dispositifs électriques. Le format de module le plus courant emploie 60 cellules carrées (ou « pseudo-carrées »), de 156 mm de côté, réparties en six chaînes (« strings » en anglais) de dix cellules connectées en série. Les six chaînes de cellules photovoltaïques sont également connectées en série. La tension de circuit ouvert aux bornes du module est alors égale à 60 fois la tension de seuil d'une cellule photovoltaïque. Le courant électrique du module correspond approximativement au courant fourni par chaque cellule photovoltaïque (en pratique, les cellules photovoltaïques n'ont pas exactement les mêmes performances et le courant électrique est limité par la cellule la moins performante du module).

Avec les dernières technologies de cellules photovoltaïques, notamment la technologie PERT (pour « Passivated Emitter and Rear Totally diffused » en anglais), le courant d'une cellule monofaciale de 156 mm x 156 mm en superficie atteint des valeurs élevées, de l'ordre de 9 A pour une irradiance solaire de 1000 W/m². Ces valeurs de courant sont augmentées d'environ 20 % lorsqu'on utilise une cellule bifaciale, du fait du rayonnement solaire diffus capté en face arrière de la cellule. Ce fort courant électrique circule dans les éléments d'interconnexion entre les cellules du module et occasionne des pertes résistives importantes.

Afin de réduire ces pertes résistives, une solution consiste à assembler des modules avec des cellules photovoltaïques de superficie plus faible, et donc de courant plus faible. Ces cellules de plus faible superficie sont communément appelées « sous-cellules » et obtenues par découpage de cellules photovoltaïques de pleine taille (ex. 156 mm x 156 mm).

La découpe d'une cellule photovoltaïque crée de nouveaux bords qui, à la différence de la face avant et de la face arrière de la cellule, ne sont pas recouverts par des couches de passivation. Par ailleurs, la découpe (au laser par exemple) est susceptible de créer des défauts et d'introduire des impuretés à proximité du plan de coupe. Ces défauts et impuretés diminuent la durée de vie des porteurs de charge libres en agissant comme centres de recombinaison des paires électron-trou, ce qui se traduit par une diminution du rendement de la cellule. Ce phénomène est particulièrement prononcé pour les cellules photovoltaïques à hétérojonction (HET), qui possèdent par nature très peu de défauts de surface et où la création de quelques défauts localisés suffit à réduire les performances électriques de la cellule de manière significative.

Pour optimiser les performances des sous-cellules photovoltaïques, il est donc nécessaire de passiver également les bords nouvellement créés de ces sous-cellules.

La demande internationale WO2012/057823 A2 décrit un procédé de découpe et de passivation d'un dispositif semi-conducteur, tel qu'une cellule photovoltaïque. Après découpe de la cellule photovoltaïque, une couche de passivation est déposée en couches atomiques (i.e. par ALD, « Atomic Layer Déposition » en anglais) sur la face supérieure et les parois latérales de la cellule découpée. Le matériau de la couche de passivation est par exemple de l'alumine (Al₂O₃) ou du dioxyde de silicium (SiO₂). Le dépôt en couches atomiques est suivi d'une étape de gravure ionique réactive (ou RIE, pour « Reactive Ion Etching » en anglais) afin d'éliminer l'excès de matériau en face supérieure de la cellule découpée et de limiter la couche de passivation aux parois latérales de la cellule. La découpe de la cellule photovoltaïque peut être réalisée en créant, avec un laser, un sillon à la surface de la cellule, puis en clivant mécaniquement la cellule à partir de ce sillon.

La technique de dépôt ALD permet d'obtenir un revêtement conforme et dense ayant de bonnes propriétés de passivation. Elle est toutefois lourde à mettre en oeuvre, car le dépôt s'effectue dans un réacteur dont l'enceinte est mise sous vide partiel. En outre, l'enceinte du réacteur ne peut accueillir qu'un nombre limité de substrats semi-conducteurs.

Le procédé du document WO2012/057823 ne permet donc pas la passivation de cellules photovoltaïques avec une cadence de production qui soit compatible avec celle des autres étapes de fabrication de cellules photovoltaïques. Par ailleurs, l'étape de gravure RIE augmente le temps de fabrication d'une cellule photovoltaïque.

### RÉSUMÉ DE L'INVENTION

Il existe donc un besoin de prévoir un procédé de passivation de cellules photovoltaïques ayant une cadence de production élevée, de façon à être compatible avec des exigences de production industrielle.

Selon un premier aspect de l'invention, on tend à satisfaire ce besoin en prévoyant un procédé de passivation de cellules photovoltaïques comprenant chacune une face avant destinée à être exposée à un rayonnement incident, une face arrière opposée à la face avant et des surfaces latérales reliant la face avant et la face arrière, ledit procédé comprenant les étapes suivantes :
- former un groupe de cellules photovoltaïques ;
- former une couche de passivation par dépôt spatial de couches atomiques simultanément sur plusieurs des cellules photovoltaïques du groupe, de telle façon que la couche de passivation recouvre au moins une des surfaces latérales de chaque cellule photovoltaïque, moins de 5 % de la superficie de la face avant de chaque cellule photovoltaïque et moins de 5 % de la superficie de la face arrière de chaque cellule photovoltaïque.

Contrairement au dépôt ALD classique (dit « temporel ») qui affecte toute la surface d'une cellule photovoltaïque (en l'absence de masque), la technique du dépôt spatial de couches atomiques ou SALD (pour « Spatial Atomic Layer Déposition » en anglais) permet de localiser le dépôt d'un matériau de passivation au voisinage d'un bord seulement de la cellule. Grâce à cette technique, les surfaces latérales de plusieurs cellules photovoltaïques peuvent être passivées simultanément en les rapprochant les unes des autres, tout en évitant une étape de gravure supplémentaire du matériau de passivation en dehors des surfaces latérales. La technique SALD permet en outre un dépôt à pression atmosphérique et à une cadence élevée, ce qui contribue à la réduction du coût de production des cellules photovoltaïques.

L'absence de couche de passivation sur la totalité de la face avant et/ou la face arrière des cellules photovoltaïques facilite l'étape d'interconnexion ultérieure des cellules photovoltaïques. En effet, les cellules photovoltaïques comprennent en face avant et/ou en face arrière des métallisations (ex. doigts de collecte, busbars) sur lesquelles sont soudées ou collées des éléments d'interconnexion (rubans, fils...). Il est préférable de ne pas recouvrir ces métallisations avec la couche de passivation pour ne pas perturber le collage ou la soudure des éléments d'interconnexion.

Dans un premier mode de mise en oeuvre du procédé de passivation, le groupe de cellules photovoltaïques comprend des première et deuxième cellules photovoltaïques espacées l'une de l'autre et reposant sur l'une de leurs faces avant et arrière, l'une des surfaces latérales de la première cellule photovoltaïque faisant face à l'une des surfaces latérales de la deuxième cellule photovoltaïque.

Selon un développement de ce premier mode de mise en oeuvre, la couche de passivation est déposée simultanément sur les première et deuxième cellules photovoltaïques au moyen d'une tête de distribution de gaz, la tête de distribution de gaz présentant une surface de sortie des gaz de largeur supérieure ou égale à la distance séparant les première et deuxième cellules photovoltaïques.

De préférence, le groupe de cellules photovoltaïques comprend une pluralité de cellules photovoltaïques empilées les unes sur les autres.

Dans un deuxième mode de mise en oeuvre du procédé de passivation, les cellules photovoltaïques du groupe forment une seule pile et reposent sur une de leurs surfaces latérales ou sur l'une de leurs faces avant et arrière.

Selon un développement de ce deuxième mode de mise en oeuvre, la couche de passivation est formée simultanément sur toutes les cellules photovoltaïques du groupe au moyen d'une tête de distribution de gaz, la tête de distribution de gaz comprenant une surface de sortie des gaz de largeur supérieure ou égale à la hauteur de la pile.

Dans un troisième mode de mise en oeuvre du procédé de passivation, les cellules photovoltaïques du groupe forment deux piles disposées en regard l'une de l'autre et reposent sur l'une de leurs faces avant et arrière.

Selon un développement de ce troisième mode de mise en oeuvre, la couche de passivation est formée simultanément sur toutes les cellules photovoltaïques du groupe au moyen d'une tête de distribution de gaz, la tête de distribution de gaz étant positionnée entre les deux piles et comprenant deux surfaces de sortie des gaz opposées de largeur supérieure ou égale à la hauteur de chaque pile.

Le procédé de passivation selon le premier aspect de l'invention peut également présenter une ou plusieurs des caractéristiques ci-dessous, considérées individuellement ou selon toutes les combinaisons techniquement possibles :
- la couche de passivation est formée d'alumine (Al₂O₃), de dioxyde de silicium (SiO₂), de nitrure de silicium (Si₃N₄) ou de nitrure de silicium amorphe hydrogéné (a-SiₓN_{y} :H) ;
- le nombre de cellules photovoltaïques dans chaque pile est supérieur ou égal à 100.

Un deuxième aspect de l'invention concerne un procédé de fabrication de sous-cellules photovoltaïques passivées, comprenant les étapes suivantes :
- fournir des cellules photovoltaïques comprenant chacune une face avant destinée à être exposée à un rayonnement incident et une face arrière opposée à la face avant ;
- découper les cellules photovoltaïques pour former une pluralité de sous-cellules photovoltaïques, chaque sous-cellule photovoltaïque comprenant une face avant destinée à être exposée au rayonnement incident, une face arrière opposée à la face avant et des surfaces latérales reliant les faces avant et arrière de la sous-cellule photovoltaïque, au moins une des surfaces latérales, dite additionnelle, résultant du découpage d'une cellule photovoltaïque ;
- recouvrir d'une couche de passivation au moins une surface latérale additionnelle des sous-cellules photovoltaïques, en suivant un procédé de passivation tel que décrit ci-dessus.

Dans un mode de mise en oeuvre préférentiel de ce procédé de fabrication, le découpage de chaque cellule photovoltaïque comprend une étape d'exposition d'une des faces avant et arrière de la cellule photovoltaïque à un laser pour former une tranchée et une étape de clivage mécanique de la cellule photovoltaïque à partir de la tranchée.

De préférence, la couche de passivation recouvre en outre au moins une bande de la face exposée par le laser, ladite au moins une bande étant contigüe à ladite au moins une surface latérale additionnelle et représentant moins de 5 % de la superficie de la face exposée par le laser.

Les cellules photovoltaïques sont par exemple découpées en demi-cellules ou en sous-unités de superficie inférieure à celle d'une demi-cellule.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
[Fig 1A] illustre une étape d'un procédé de fabrication de sous-cellules photovoltaïques.
[Fig 1B] illustre une étape d'un procédé de fabrication de sous-cellules photovoltaïques.
[Fig 1C] illustre une étape d'un procédé de fabrication de sous-cellules photovoltaïques.
[Fig 2] représente une tête de dépôt SALD permettant de passiver un bord découpé d'une sous-cellule.
[Fig 3] représente un premier mode de mise en oeuvre d'un procédé de passivation de cellules photovoltaïques selon l'invention.
[Fig 4] représente un deuxième mode de mise en oeuvre du procédé de passivation selon l'invention.
[Fig 5] représente un troisième mode de mise en oeuvre du procédé de passivation selon l'invention.
[Fig 6] représente une tête de dépôt SALD conçue pour passiver simultanément deux piles de cellules photovoltaïques.

Pour plus de clarté, les éléments identiques ou similaires sont repérés par des signes de référence identiques sur l'ensemble des figures.

### DESCRIPTION DÉTAILLÉE D'AU MOINS UN MODE DE RÉALISATION

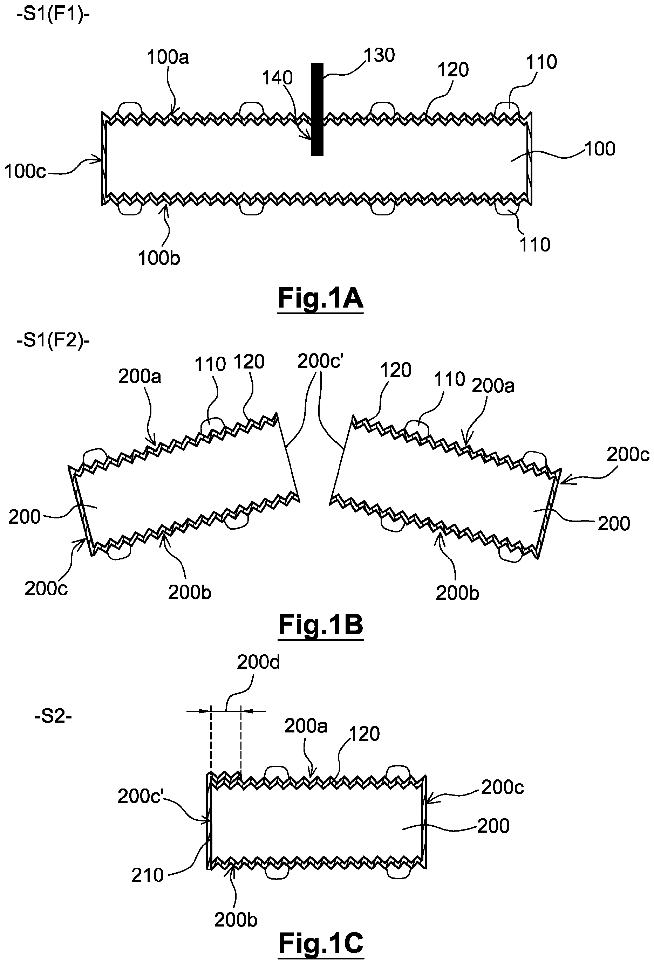

Les figures 1A à 1C représentent un mode de mise en oeuvre préférentiel d'un procédé de fabrication de sous-cellules photovoltaïques. Une sous-cellule photovoltaïque désigne ici une portion ou un morceau d'une cellule photovoltaïque de pleine taille, aussi qualifiée de cellule photovoltaïque « entière ». Les sous-cellules photovoltaïques sont par exemple destinées à la fabrication de modules photovoltaïques ayant des pertes résistives faibles comparées à celles des modules photovoltaïques classiques (composés de cellules photovoltaïques entières).

Ce procédé de fabrication comprend une étape S1 consistant à découper des cellules photovoltaïques 100 de pleine taille en une pluralité de sous-cellules 200 (cf. Figs.1A-1B) et une étape S2 de passivation des sous-cellules 200 (cf. Fig.1C). Dans un souci de clarté, seule une cellule photovoltaïque 100 et une sous-cellule 200 ont été représentées (en vue de coupe) sur les figures 1A et 1C respectivement.

Les cellules photovoltaïques 100 ont été préalablement fabriquées à partir de substrats semi-conducteurs, par exemple en silicium cristallin. Ces substrats ont été initialement découpés dans un lingot de silicium, puis ont été soumis à plusieurs étapes de fabrication (par exemple des étapes de structuration de surface, dopage, recuit, passivation, sérigraphie...), mais aucune autre étape de découpage.

Les cellules photovoltaïques 100 comprennent chacune une face avant 100a destinée à être exposée au rayonnement solaire incident, une face arrière 100b opposée à la face avant 100a et des parois latérales 100c reliant la face avant 100a et la face arrière 100b. Vues de face (avant ou arrière), les cellules photovoltaïques 100 ont de préférence une forme carrée ou pseudo-carrée. Dans le format pseudo-carré, les quatre coins des cellules photovoltaïques 100 sont tronqués ou arrondis. Les dimensions de la face avant 100a et de la face arrière 100b sont généralement standardisées, par exemple 156 mm x 156 mm.

Les cellules photovoltaïques 100 peuvent être des cellules monofaciales ou bifaciales. Dans une cellule monofaciale, seule la face avant 100a de la cellule capte le rayonnement solaire. Dans une cellule bifaciale, les deux faces 100a-100b de la cellule captent le rayonnement solaire. La face avant 100a est alors celle permettant d'obtenir le maximum de courant électrique lorsqu'elle est tournée vers le soleil.

De préférence, les cellules photovoltaïques 100 sont prêtes à être interconnectées en une chaîne de cellules. Elles sont munies en face avant 100a et/ou en face arrière 100b d'une ou plusieurs métallisations 110 destinées à collecter les porteurs de charge photogénérés et à recevoir des éléments d'interconnexion, par exemple des fils ou rubans métalliques. Les métallisations 110 sont de préférence des pistes électriquement conductrices appelées « busbars ». Les busbars 110 peuvent relier électriquement des doigts de collecte (non représentés sur la figure 1A) répartis sur toute la superficie des faces avant 100a et/ou arrière 100b. La face arrière 100b des cellules photovoltaïques 100 peut aussi être entièrement métallisée. Dans une variante de mise en oeuvre, les cellules photovoltaïques 100 sont dépourvues de busbars 110 mais comportent uniquement des doigts de collecte.

La face avant 100a et la face arrière 100b de chaque cellule photovoltaïque 100 présentent avantageusement une couche de passivation 120. Cette couche de passivation 120 rend inactifs les défauts de surface de la cellule photovoltaïque 100 et améliore la durée de vie des porteurs de charge photogénérés. De préférence, la couche de passivation 120 recouvre également les surfaces latérales 100c de la cellule photovoltaïque 100.

Dans ce mode de mise en oeuvre préférentiel, le découpage de chaque cellule photovoltaïque 100 s'effectue en deux opérations successives F1 et F2, illustrées respectivement par les figures 1A et 1B.

L'opération F1 est une opération dite d'amorçage de la découpe qui consiste à exposer l'une des faces avant et arrière de la cellule photovoltaïque 100 (la face avant 100a dans l'exemple de la figure 1A) à un laser 130 afin de former une tranchée 140. La profondeur de la tranchée 140 est strictement inférieure à l'épaisseur de la cellule photovoltaïque 100. La profondeur de la tranchée 140 est de préférence comprise entre 50 µm et 150 µm, alors que l'épaisseur de la cellule photovoltaïque 100 est typiquement comprise entre 150 µm et 200 µm.

Pour limiter l'endommagement de la cellule de part et d'autre de la tranchée 140, le laser 130 est avantageusement pulsé, les impulsions ayant une durée comprise entre 10⁻⁶ s et 10⁻¹⁵ s.

La formation de la tranchée 140 au moyen du laser 130 crée une zone de fragilité qui facilite le clivage mécanique de la cellule, lors de l'opération F2 (cf. Fig. 1B). Le clivage mécanique s'effectue dans le plan de la tranchée 140, au départ de celle-ci, de préférence en exerçant des forces identiques de part et d'autre de la tranchée 140.

Les cellules photovoltaïques 100 sont de préférence découpées en deux (cf. Fig. 1B), quatre ou six sous-cellules 200 de même superficie. Les sous-cellules 200 sont alors des demi-cellules, des quarts de cellule ou des sixièmes de cellule. La découpe des cellules photovoltaïques 100 peut être entièrement automatisée grâce à un équipement spécifique, tel que celui décrit dans la demande de brevet CN203659909.

Chaque sous-cellule 200 comprend une face avant 200a et une face arrière 200b, correspondant respectivement à une partie de la face avant 100a et à une partie de la face arrière 100b de la cellule photovoltaïque 100 dont la sous-cellule 200 est originaire. Chaque sous-cellule 200 peut en outre présenter une ou plusieurs surfaces latérales 200c correspondant chacune à tout ou partie d'une surface latérale 100c de la cellule photovoltaïque 100. La face avant 200a, la face arrière 200b et les surfaces latérales 200c des sous-cellules 200 sont donc avantageusement recouvertes de la couche de passivation 120.

À l'instar des cellules photovoltaïques 100, les sous-cellules 200 sont prêtes à être interconnectées. Une partie des métallisations 110 de la cellule photovoltaïque 100 est présente en face avant et/ou en face arrière de chaque sous-cellule 200.

Chaque sous-cellule 200 comprend également une ou plusieurs surfaces latérales additionnelles 200c' résultant du découpage de la cellule photovoltaïque 100. Ces surfaces latérales additionnelles 200c' constituent des zones où le matériau semi-conducteur (ex. silicium) a été mis à nu. Autrement dit, ces surfaces latérales additionnelles 200c' sont dépourvues de couche de passivation, à la différence de la face avant 200a, de la face arrière 200b et des (éventuelles) autres surfaces latérales 200c de la sous-cellule 200. Par exemple, lorsqu'une cellule photovoltaïque 100 est découpée en quatre bandes de cellule parallèles, deux bandes de cellule présentent deux bords parallèles non passivés, et deux autres bandes de cellule présentent un seul bord non passivé.

En référence à la figure 1C, le procédé de fabrication comprend ensuite une étape S2 de passivation d'au moins un bord découpé des sous-cellules 200, et de préférence de tous les bords découpés. Cette étape vise à neutraliser les défauts de la surface latérale additionnelle 200c' correspondant audit bord découpé, et de préférence de toutes les surfaces latérales additionnelles 200c'. Ainsi, il est possible de limiter la diminution du rendement photovoltaïque des sous-cellules 200 qui est liée à la génération de nouveau(x) bord(s) par découpage.

Lors de l'étape S2, une couche de passivation 210 est formée par dépôt spatial de couches atomiques ou SALD (pour « Spatial Atomic Layer Déposition » en anglais) sur au moins une surface latérale additionnelle 200c' des sous-cellules 200.

La technique de dépôt spatial de couches atomiques (SALD) est une variante de la technique de dépôt de couches atomiques ALD classique (dite « temporelle »). Dans cette variante, les différents gaz précurseurs sont séparés dans l'espace plutôt que dans le temps. Les gaz précurseurs sont acheminés en continu vers des régions différentes du substrat sur lequel on souhaite déposer une ou plusieurs couches atomiques. Les flux de gaz précurseurs sont séparés deux à deux par un rideau de gaz inerte ou une aspiration générée par une pompe à vide. Une couche atomique est formée sur une zone du substrat en exposant cette zone au flux d'un premier précurseur, qui réagit avec les terminaisons et forme une monocouche contenant d'autres terminaisons (groupes réactifs) sur lesquels les molécules d'un deuxième précurseur peuvent réagir en formant une liaison chimique. De préférence, le premier précurseur contient du silicium ou un métal, tel que l'aluminium, et le deuxième précurseur contient de l'oxygène.

La technique SALD permet d'effectuer un dépôt de couches minces à pression atmosphérique et sans enceinte de confinement. Elle est donc plus simple à mettre en oeuvre que la technique ALD classique. Par ailleurs, la vitesse de dépôt est augmentée de plusieurs ordres de grandeur par rapport à la technique ALD classique. La technique SALD présente ainsi de nombreux avantages, particulièrement appréciables dans le cadre de la fabrication de cellules solaires où une cadence de production élevée et une réduction des coûts de production sont recherchées.

L'étape de dépôt S2 par SALD est avantageusement accomplie à l'aide d'une tête de dépôt dimensionnée de sorte que le dépôt des couches de passivation soit localisé sur une partie seulement des sous-cellules 200. Les dimensions de la tête de dépôt sont de préférence inférieures à celles des sous-cellules 200, par exemple inférieures à 60 mm.

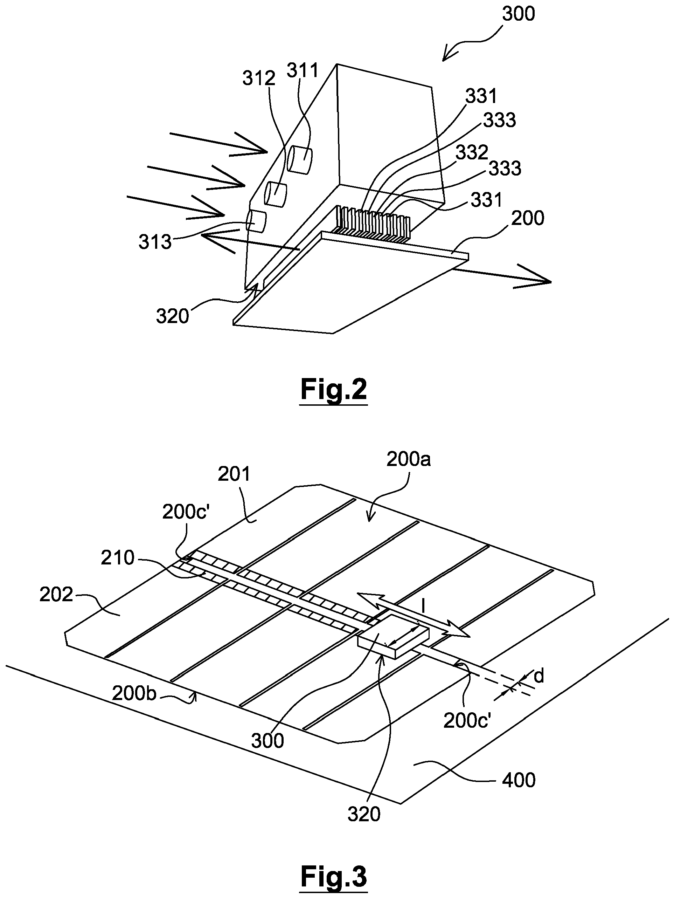

La figure 2 représente à titre d'exemple une tête de dépôt SALD 300 permettant de déposer la couche de passivation 210 sur une sous-cellule 200. La tête de dépôt 300 comprend un premier conduit d'entrée 311 transportant le premier gaz précurseur, un deuxième conduit d'entrée 312 transportant le gaz inerte et un troisième conduit d'entrée 313 transportant le deuxième gaz précurseur. Des canaux de distribution (non représentés sur la figure 2) acheminent les gaz depuis les conduits d'entrée 311-313 vers une surface de sortie des gaz 320. La surface de sortie des gaz 320 délivre des flux de premier gaz précurseur 331 en alternance avec des flux de deuxième gaz précurseur 332 et des flux de gaz neutre 333 entre les flux de gaz précurseur 331-332.

La tête de dépôt 300 est placée à faible distance (typiquement inférieure à 1 mm) de la sous-cellule 200 et se déplace de façon relative par rapport à la sous-cellule 200, de façon à déposer successivement plusieurs couches monoatomiques sur la sous-cellule 200. L'ensemble des couches monoatomiques forme la couche de passivation 210. L'épaisseur de la couche de passivation 210 varie en fonction du nombre de couches monoatomiques déposées. Elle est de préférence comprise entre 10 nm et 100 nm. La sous-cellule 200 peut être placée sur un support mobile (non représenté) qui se déplace sous les flux de gaz émis par la tête de dépôt 300. La tête de dépôt 300 est alors avantageusement immobile. Alternativement, la tête de dépôt 300 est mobile et se déplace le long du bord à passiver de la sous-cellule 200, qui reste immobile. La sous-cellule 200 et la tête de dépôt 300 peuvent être également toutes les deux mobiles. La sous-cellule 200 peut être chauffée à une température comprise entre 25 °C et 300 °C pendant l'étape de dépôt S2, afin de garantir une vitesse de dépôt constante. Le dépôt par SALD peut également être assisté par plasma (comme réalisé classiquement avec la technique PECVD ou PEALD).

Le matériau de la couche de passivation est par exemple de l'alumine (Al₂O₃), du dioxyde de silicium (SiO₂), de nitrure de silicium (Si₃N₄) ou de nitrure de silicium amorphe hydrogéné (a-SiₓN_{y} :H).

Comme illustré sur la figure 1C, les conditions du dépôt (telles que la position de la tête de dépôt 300 par rapport à la sous-cellule 200, les débits de gaz, la concentration des précurseurs et la température) et les dimensions de la tête d'injection sont avantageusement choisies de façon à ce que la couche de passivation 210 recouvre en outre une bande 200d de la face impactée par le laser (la face avant 200a dans l'exemple des figures 1A-1C). Cette bande est contiguë à la surface latérale additionnelle 200c' recouverte par la couche de passivation 210. Ainsi, les défauts créés par le laser en face avant ou arrière des sous-cellules 200, au voisinage des bords découpés, peuvent être neutralisés au même titre que les défauts présents sur la surface latérale additionnelle 200c'.

Le dépôt de la couche de passivation 210 sur la face impactée par le laser et sur la surface latérale 200c' est avantageusement réalisé en une seule fois (la technique SALD bénéficiant d'aussi bonnes performances que l'ALD en termes de conformité du dépôt).

Lorsque la sous-cellule 200 comprend plusieurs surfaces latérales additionnelles 200c' et que plusieurs d'entre elles sont passivées par SALD à l'étape S2, la couche de passivation 210 recouvre avantageusement plusieurs bandes 200d de la face impactée par le laser, chaque bande 200d étant contiguë à l'une des surfaces latérales additionnelles 200c' passivées.

L'ensemble des bandes 200d recouvertes par la couche de passivation 210 représente moins de 5 % de la superficie de la face exposée par le laser. Autrement dit, les métallisations 110 présentes sur cette face ne sont pratiquement pas recouvertes de la couche de passivation 210. En conséquence, l'étape ultérieure d'interconnexion des sous-cellules 200 (dans le but de former des chaînes de sous-cellules, puis des modules photovoltaïques) n'est pas complexifiée. Ceci permet également de n'exclure aucune technique d'interconnexion. Les techniques d'interconnexion par collage ou par soudage, avec des rubans ou des fils, peuvent être toutes employées à la suite du procédé des figures 1A-1C.

Selon l'invention, plusieurs sous-cellules 200 sont passivées simultanément. La technique SALD permet en effet de déposer (localement) un matériau de passivation sur plusieurs sous-cellules 200 simultanément.

Un procédé de passivation de cellules photovoltaïques par SALD a par ailleurs été développé dans le but d'offrir une cadence de production élevée et d'optimiser la consommation des gaz précurseurs.

Dans ce procédé de passivation, plusieurs cellules photovoltaïques sont rassemblées pour former un groupe de cellules. Les surfaces latérales à passiver appartenant aux différentes cellules du groupe peuvent être placées à une distance proche les unes des autres, typiquement à une distance inférieure à 5 mm, de préférence inférieure à 1 mm, et même juxtaposées. Puis, une tête de dépôt SALD se déplace de façon relative par rapport aux cellules photovoltaïques de façon à former une couche de passivation simultanément sur plusieurs des cellules photovoltaïques du groupe, et de préférence sur toutes les cellules photovoltaïques du groupe. Les conditions du dépôt sont telles que la couche de passivation recouvre au moins une des surfaces latérales de chaque cellule photovoltaïque, moins de 5 % de la superficie de la face avant de chaque cellule photovoltaïque et moins de 5 % de la superficie de la face arrière de chaque cellule photovoltaïque.

Dans un mode de mise en oeuvre du procédé de passivation, la couche de passivation ne s'étend pas sur les faces avant et arrière des cellules photovoltaïques, mais uniquement les surfaces latérales des cellules photovoltaïques.

Le procédé de passivation est applicable quelles que soient les dimensions des cellules photovoltaïques. En particulier, il est applicable aussi bien à des cellules photovoltaïques de pleine taille (ex. 156 mm x 156 mm) qu'à des morceaux de cellules (ou sous-cellules) obtenus par découpage. Ce procédé est donc avantageusement mis en oeuvre à l'étape S2 du procédé de fabrication de sous-cellules (décrit ci-dessus en relation avec les figures 1A-1C).

Plusieurs modes de mise en oeuvre du procédé de passivation de cellules photovoltaïques sont décrits ci-après en relation avec les figures 3 à 5. Ces modes de mise en oeuvre prennent pour exemple des sous-cellules (200, 201, 202), ayant chacune un bord découpé, c'est-à-dire une surface latérale additionnelle 200c' à passiver (cas des demi-cellules).

La figure 3 illustre un premier mode de mise en oeuvre du procédé de passivation, dans lequel une première sous-cellule 201 et une deuxième sous-cellule 202 sont disposées à plat sur un support 400, qui peut être mobile ou immobile. La bande (ou le tapis) d'un convoyeur constitue un exemple de support mobile. Les sous-cellules 201 et 202 reposent ainsi sur l'une de leurs faces avant et arrière, aussi appelées faces principales, par exemple la face arrière 200b. Les sous-cellules 201 et 202 sont espacées l'une de l'autre, de préférence d'une distance d comprise entre 1 mm et 5 mm. La surface latérale additionnelle 200c' de la première sous-cellule 201 fait face à la surface latérale additionnelle 200c' de la deuxième sous-cellule 202. Les bords découpés des sous-cellules 201 et 202 sont de préférence rectilignes et parallèles entre eux. La distance d est alors constante sur toute la longueur des bords découpés.

Une tête de dépôt SALD 300 est positionnée au-dessus de l'interstice entre les sous-cellules 201-202 et se déplace (de façon relative par rapport au support 400 des sous-cellules) le long des bords découpés des sous-cellules 201-202. La tête de dépôt 300 recouvre ainsi simultanément les deux surfaces latérales additionnelles 200c' de la couche de passivation 210. La surface de sortie des gaz 320 de la tête de dépôt 300 présente une largeur I supérieure ou égale à la distance d séparant les sous-cellules 201 et 202. La largeur I et la distance d sont mesurées perpendiculairement aux bords découpés des sous-cellules 201 et 202 dans un plan parallèle aux faces avant et arrière 200a-200b.

La largeur I de la surface de sortie des gaz 320 est de préférence supérieure à la distance d entre les sous-cellules 201 et 202, de sorte que la couche de passivation 210 recouvre en outre une bande 200d de l'autre des faces principales, ici la face avant 200a. La face avant 200a est par exemple la face principale des sous-cellules 201-202 ayant été exposée à un laser.

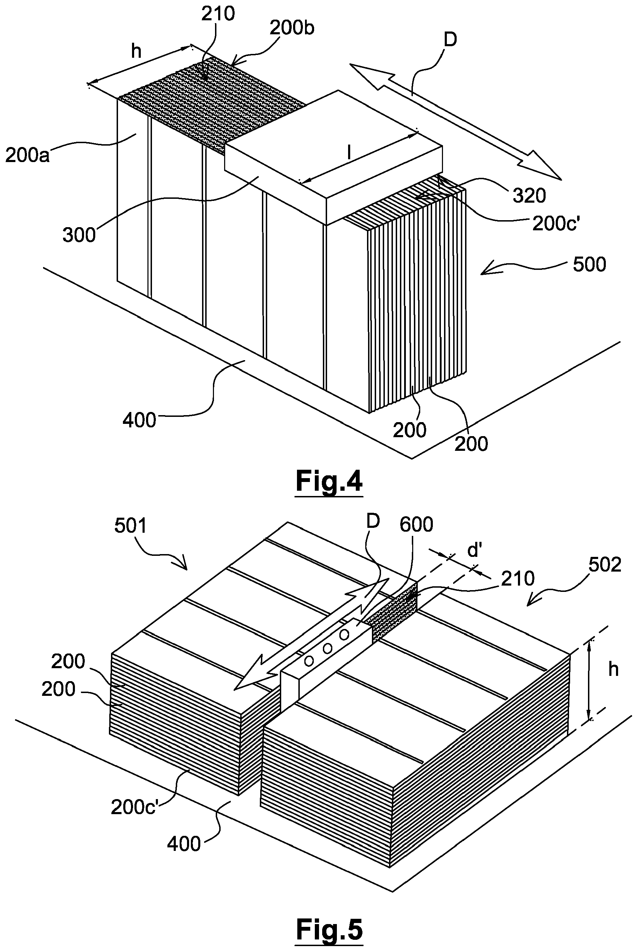

Dans les deux modes de mise en oeuvre suivants, représentés par les figures 4 et 5, des sous-cellules 200 sont empilées les unes sur les autres. Les sous-cellules 200 sont de préférence empilées en plaquant leurs faces principales, par exemple face avant 200a contre face arrière 200b. De façon alternative, des cales peuvent être disposées entre les sous-cellules 200.

Sur la figure 4, les sous-cellules 200 ne forment qu'une seule pile 500 et reposent sur la tranche, c'est-à-dire sur l'une de leurs surfaces latérales. Elles sont donc disposées verticalement sur le support 400, plutôt qu'à plat (cf. Fig.3). La tête de dépôt 300 se déplace (de façon relative par rapport aux sous-cellules) le long d'un bord découpé des sous-cellules 200, la surface de sortie des gaz 320 étant tournée vers les surfaces latérales additionnelles 200c' à passiver. Ces surfaces latérales additionnelles 200c' sont de préférence opposées aux surfaces latérales sur lesquelles reposent les sous-cellules 200. Les sous-cellules 200 ayant généralement un format rectangulaire, la surface de sortie des gaz 320 est de préférence orientée parallèlement au support 400.

Dans une variante de mise en oeuvre, les sous-cellules 200 ne forment qu'une seule pile 500 et reposent, à plat, sur l'une de leurs faces principales (avant ou arrière). Une telle disposition peut notamment faciliter le chauffage des sous-cellules 200. La surface de sortie des gaz 320 est alors orientée perpendiculairement au support 400 (plutôt que parallèlement).

La largeur I de la surface de sortie des gaz 320 est avantageusement supérieure ou égale à la hauteur h de la pile 500. Ainsi, la couche de passivation est déposée simultanément sur toutes les sous-cellules 200 de la pile 500. La tête de dépôt 300 n'a alors besoin de se déplacer que dans une seule direction D, parallèlement aux bords découpés des sous-cellules. L'équipement de dépôt peut ainsi être simplifié.

Dans le mode de mise en oeuvre de la figure 5, les sous-cellules 200 forment des première et deuxième piles 501-502 et reposent, à plat, sur l'une de leurs faces principales (avant ou arrière). Les piles 501-502 sont disposées en regard l'une de l'autre sur le support 400. Les surfaces latérales additionnelles 200c' de la première pile 501 font face aux surfaces latérales additionnelles 200c' de la deuxième pile 502. Une tête de dépôt SALD 600 se déplace (de façon relative par rapport aux piles de sous-cellules 501-502) entre les deux piles 501-502, espacées d'une distance d' comprise avantageusement entre 30 mm et 50 mm. Cette tête de dépôt 600 est configurée pour former simultanément une couche de passivation 210 sur plusieurs sous-cellules appartenant aux deux piles 501-502.

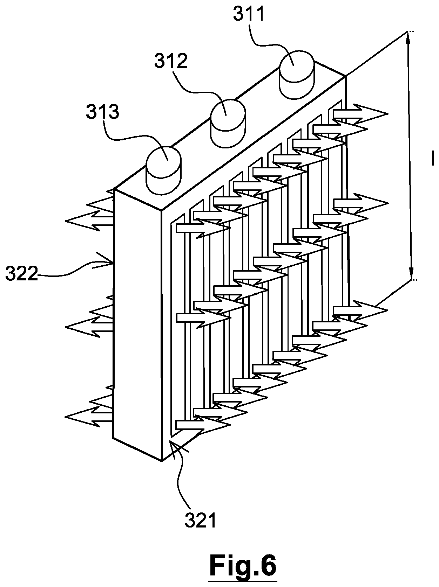

La figure 6 montre en détail la tête de dépôt 600 utilisée dans le mode de mise en oeuvre de la figure 5. La tête de dépôt 600 diffère de la tête de dépôt 300 illustrée sur la figure 2 en ce qu'elle comporte deux surfaces de sortie des gaz 321-322 opposées, au lieu d'une seule. De préférence, la tête de dépôt 600 comprend un dispositif d'obturation permettant de couper les flux de gaz délivrés par l'une des deux surfaces de sortie 321-322, afin de réaliser si besoin le dépôt sur une seule pile de sous-cellules 200.

La largeur I des surfaces de sortie des gaz 321-322 est avantageusement supérieure ou égale à la hauteur h de chacune des piles 501-502. Ainsi, la couche de passivation est formée simultanément sur toutes les sous-cellules 200 des deux piles 501-502. La tête de dépôt 600 n'a alors besoin de se déplacer que dans une seule direction D, parallèlement aux bords découpés des sous-cellules 200.

La largeur I des surfaces de sortie de gaz 320, 321, 322 et la hauteur h des piles 500, 501, 502 (cf. Figs.4-6) sont mesurées perpendiculairement aux faces principales 200a-200b des sous-cellules 200 (comme l'épaisseur des sous-cellules), quelle que soit l'orientation des sous-cellules 200 par rapport au support 400.

Une partie de la face avant 200a et de la face arrière 200b des sous-cellules 200 peut être recouverte de la couche de passivation dans les modes de mise en oeuvre des figures 4 et 5, même lorsque les sous-cellules 200 sont plaquées les unes contre les autres. En effet, suivant les conditions de dépôt (débits de gaz notamment), les gaz précurseurs peuvent diffuser sur une certaine distance vers l'intérieur des faces avant et arrière car celles-ci ne sont pas parfaitement planes. Pour ne pas gêner l'étape ultérieure d'interconnexion des sous-cellules, la couche de passivation occupe moins de 5 % de la face avant des sous-cellules et moins de 5 % de la face arrière des sous-cellules.

L'équipement de dépôt SALD comprend avantageusement un système de chauffage capable de porter à une même température les différentes surfaces latérales à passiver. Une couche de passivation de même épaisseur et de même composition peut ainsi être obtenue sur les différentes sous-cellules.

Comme indiqué précédemment, le procédé de passivation décrit en relation avec les figures 3 à 5 peut être mis en oeuvre avec des cellules photovoltaïques de pleine taille plutôt qu'avec des sous-cellules. En particulier, pour des technologies de cellules avancées telles que les cellules à hétérojonction (HET), il peut être utile d'améliorer la passivation existante des bords de cellule en formant une nouvelle couche de passivation.

Le procédé de passivation de cellules photovoltaïques selon l'invention bénéficie d'une cadence de production élevée, d'environ 15 à 30 s par groupe de cellules, compatible avec celles des autres étapes de fabrication de cellules photovoltaïques, car plusieurs cellules photovoltaïques sont traitées simultanément. Il peut donc aisément être intégré dans une ligne de production de cellules photovoltaïques.

La cadence du procédé de passivation selon les figures 4 et 5 est bien supérieure à celle du procédé selon la figure 3, du fait d'un nombre de cellules traitées simultanément bien supérieur. Le nombre de cellules dans les piles 500, 501, 502 est avantageusement supérieur ou égal à 100, de préférence compris entre 200 et 500.

Par ailleurs, d'importantes économies de gaz précurseurs sont réalisées d'une part en ne passivant pas totalement les faces avant et/ou arrière des cellules photovoltaïques (contrairement au procédé de l'art antérieur), et d'autre part, en réalisant le dépôt simultanément sur un grand nombre de cellules photovoltaïques (d'après les modes de réalisation des figures 4 et 5).

L'invention n'est pas limitée aux modes de réalisation décrits en référence aux figures et des variantes peuvent être envisagées sans sortir du cadre de l'invention. Par exemple, à l'étape S1 du procédé de fabrication de sous-cellules (cf. Figs.1A-1B), les cellules photovoltaïques 100 de pleine taille peuvent être découpées grâce à une technique autre que la prédécoupe au laser suivie du clivage mécanique, par exemple par laser seul, avec ou sans séparation thermique induite par le laser et un éventuel refroidissement, ou par rainurage mécanique.

## Revendications

1. Procédé de passivation de cellules photovoltaïques (200) comprenant chacune une face avant (200a) destinée à être exposée à un rayonnement incident, une face arrière (200b) opposée à la face avant et des surfaces latérales (200c, 200c') reliant la face avant et la face arrière, le procédé étant **caractérisé en ce qu'**il comprend les étapes suivantes :
- former un groupe de cellules photovoltaïques (200, 201, 202) ;
- former une couche de passivation (210) par dépôt spatial de couches atomiques simultanément sur plusieurs des cellules photovoltaïques du groupe, de telle façon que la couche de passivation recouvre au moins une (200c') des surfaces latérales de chaque cellule photovoltaïque (200, 201, 202), moins de 5 % de la superficie de la face avant (200a) de chaque cellule photovoltaïque et moins de 5 % de la superficie de la face arrière (200b) de chaque cellule photovoltaïque.

2. Procédé de passivation selon la revendication 1, dans lequel le groupe de cellules photovoltaïques comprend des première et deuxième cellules photovoltaïques (201, 202) espacées l'une de l'autre et reposant sur l'une de leurs faces avant et arrière (200a, 200b), l'une (200c') des surfaces latérales de la première cellule photovoltaïque (201) faisant face à l'une des surfaces latérales (200c') de la deuxième cellule photovoltaïque (202).

3. Procédé de passivation selon la revendication 2, dans lequel la couche de passivation (210) est déposée simultanément sur les première et deuxième cellules photovoltaïques (201, 202) au moyen d'une tête de distribution de gaz (300), la tête de distribution de gaz comprenant une surface de sortie des gaz (320) de largeur (I) supérieure ou égale à la distance (d) séparant les première et deuxième cellules photovoltaïques (201, 202).

4. Procédé de passivation selon la revendication 1, dans lequel le groupe de cellules photovoltaïques comprend une pluralité de cellules photovoltaïques (200) empilées les unes sur les autres.

5. Procédé de passivation selon la revendication 4, dans lequel les cellules photovoltaïques (200) du groupe forment une seule pile (500) et reposent sur une de leurs surfaces latérales (200c, 200c') ou sur l'une de leurs faces avant et arrière (200a, 200b).

6. Procédé de passivation selon la revendication 5, dans lequel la couche de passivation (210) est formée simultanément sur toutes les cellules photovoltaïques (200) du groupe au moyen d'une tête de distribution de gaz (300), la tête de distribution de gaz (300) comprenant une surface de sortie des gaz (320) de largeur (I) supérieure ou égale à la hauteur (h) de la pile (500).

7. Procédé de passivation selon la revendication 4, dans lequel les cellules photovoltaïques (200) du groupe forment deux piles (501, 502) disposées en regard l'une de l'autre et reposent sur l'une de leurs faces avant et arrière (200a, 200b).

8. Procédé de passivation selon la revendication 7, dans lequel la couche de passivation (210) est formée simultanément sur toutes les cellules photovoltaïques (200) du groupe au moyen d'une tête de distribution de gaz (600), la tête de distribution de gaz (600) étant positionnée entre les deux piles (501, 502) et comprenant deux surfaces de sortie des gaz (321, 322) opposées de largeur (I) supérieure ou égale à la hauteur (h) de chaque pile.

9. Procédé de passivation selon l'une des revendications 1 à 8, dans lequel la couche de passivation (210) est formée d'alumine (Al₂O₃), de dioxyde de silicium (SiO₂), de nitrure de silicium (Si₃N₄) ou de nitrure de silicium amorphe hydrogéné (a-SiₓN_{y} :H).

10. Procédé de fabrication de sous-cellules photovoltaïques (200) passivées, comprenant les étapes suivantes :
- fournir des cellules photovoltaïques (100) comprenant chacune une face avant (100a) destinée à être exposée à un rayonnement incident et une face arrière (100b) opposée à la face avant ;
- découper (S1) les cellules photovoltaïques (100) pour former une pluralité de sous-cellules photovoltaïques (200), chaque sous-cellule photovoltaïque comprenant une face avant (200a) destinée à être exposée au rayonnement incident, une face arrière (200b) opposée à la face avant et des surfaces latérales (200c, 200c') reliant les faces avant et arrière de la sous-cellule photovoltaïque, au moins une (200c') des surfaces latérales de chaque sous-cellule photovoltaïque (200), dite additionnelle, résultant du découpage d'une cellule photovoltaïque (100) ;
- recouvrir (S2) d'une couche de passivation (210) au moins une surface latérale additionnelle (200c') des sous-cellules photovoltaïques, en suivant un procédé de passivation selon l'une quelconque des revendications 1 à 8.

11. Procédé de fabrication selon la revendication 10, dans lequel le découpage de chaque cellule photovoltaïque (100) comprend une étape (F1) d'exposition d'une des faces avant et arrière (100a, 100b) de la cellule photovoltaïque à un laser (130) pour former une tranchée (140) et une étape (F2) de clivage mécanique de la cellule photovoltaïque (100) à partir de la tranchée (140).

12. Procédé de fabrication selon la revendication 11, dans lequel la couche de passivation (210) recouvre en outre au moins une bande (200d) de la face exposée par le laser (130), ladite au moins une bande étant contigüe à ladite au moins une surface latérale additionnelle (200c') et représentant moins de 5 % de la superficie de la face exposée par le laser.

13. Procédé de fabrication selon l'une quelconque des revendications 10 à 12, dans lequel les cellules photovoltaïques (100) sont découpées en demi-cellules (200) ou en sous-unités de superficie inférieure à celle d'une demi-cellule.

## Patentansprüche

1. Passivierungsverfahren von photovoltaischen Zellen (200), die jeweils eine Vorderseite (200a), die dazu bestimmt ist, einer einfallenden Bestrahlung ausgesetzt zu werden, eine Rückseite (200b), die der Vorderseite entgegengesetzt ist, und Seitenflächen (200c, 200c'), die die Vorderseite und die Rückseite verbinden, umfassen, wobei das Verfahren **dadurch gekennzeichnet ist, dass** es die folgenden Schritte umfasst:
- Bilden einer Gruppe von photovoltaischen Zellen (200, 201, 202);
- Bilden einer Passivierungsschicht (210) per räumlichem Aufbringen von Atomschichten gleichzeitig auf mehrere der photovoltaischen Zellen der Gruppe derart, dass die Passivierungsschicht wenigstens eine der (200c') der Seitenflächen jeder photovoltaischen Zelle (200, 201, 202), weniger als 5 % der Oberfläche der Vorderseite (200a) jeder photovoltaischen Zelle und weniger als 5 % der Oberfläche der Rückseite (200b) jeder photovoltaischen Zelle abdeckt.

2. Passivierungsverfahren gemäß Anspruch 1, bei dem die Gruppe photovoltaischer Zellen erste und zweite photovoltaische Zellen (201, 202) umfasst, die voneinander beabstandet sind und auf einer ihrer Vorder- und Rückseiten (200a, 200b) ruhen, wobei eine (200c') der Seitenflächen der ersten photovoltaischen Zelle (201) an einer der Seitenflächen (200c') der zweiten photovoltaischen Zelle (2002) gegenüber angeordnet wird.

3. Passivierungsverfahren gemäß Anspruch 2, bei dem die Passivierungsschicht (210) gleichzeitig auf den ersten und den zweiten photovoltaischen Zellen (201, 202) mittels eines Gasverteilerkopfes (300) aufgebracht wird, wobei der Gasverteilerkopf eine Gasausgangsfläche (320) mit einer Breite (I) umfasst, die größer als oder gleich der Entfernung (d) ist, die die erste und die zweite photovoltaische Zelle (201, 202) trennt.

4. Passivierungsverfahren gemäß Anspruch 1, bei dem die Gruppe photovoltaischer Zellen eine Vielzahl von photovoltaischen Zellen (200) umfasst, die übereinander gestapelt werden.

5. Passivierungsverfahren gemäß Anspruch 4, bei dem die photovoltaischen Zellen (200) der Gruppe einen einzigen Stapel (500) bilden und auf einer ihrer Seitenflächen (200c, 200c') oder auf einer ihrer Vorder- und Rückseiten (200a, 200b) ruhen.

6. Passivierungsverfahren gemäß Anspruch 5, bei dem die Passivierungsschicht (210) gleichzeitig auf allen photovoltaischen Zellen (200) der Gruppe mittels eines Gasverteilerkopfes (300) gebildet wird, wobei der Gasverteilerkopf (300) eine Gasausgangsfläche (320) mit einer Breite (I) umfasst, die größer als oder gleich der Höhe (h) des Stapels (500) ist.

7. Passivierungsverfahren gemäß Anspruch 4, bei dem die photovoltaischen Zellen (200) der Gruppe zwei Stapel (501, 502) bilden, die einander gegenüber angeordnet sind und auf einer ihrer Vorder- und Rückseiten (200a, 200b) ruhen.

8. Passivierungsverfahren gemäß Anspruch 7, bei dem die Passivierungsschicht (210) gleichzeitig auf allen photovoltaischen Zellen (200) der Gruppe mittels eines Gasverteilerkopfes (600) gebildet wird, wobei der Gasverteilerkopf (600) zwischen den zwei Stapeln (501, 502) angeordnet wird und zwei entgegengesetzte Gasausgangsflächen (321, 322) mit einer Breite (I) umfasst, die größer als oder gleich der Höhe (h) jedes Stapels ist.

9. Passivierungsverfahren gemäß einem der Ansprüche 1 bis 8, bei dem die Passivierungsschicht (210) aus Aluminiumoxid (Al₂O₃), Siliziumdioxid (SiO₂), Siliziumnitrid (Si₃N₄) oder amorphem, hydrierten Siliziumnitrid (a-SiₓN_{y}: H) gebildet wird.

10. Herstellungsverfahren von passivierten photovoltaischen Teilzellen (200), umfassend die folgenden Schritte:
- Liefern von photovoltaischen Zellen (100), die jeweils eine Vorderseite (100a), die dazu bestimmt ist, einer einfallenden Bestrahlung ausgesetzt zu werden, und eine Rückseite (100b), die der Vorderseite entgegengesetzt ist, umfassen;
- Zuschneiden (S1) der photovoltaischen Zellen (100) zum Bilden einer Vielzahl von photovoltaischen Teilzellen (200), wobei jede photovoltaische Teilzelle eine Vorderseite (200a), die dazu bestimmt ist, der einfallenden Strahlung ausgesetzt zu werden, eine Rückseite (200b), die der Vorderseite entgegengesetzt ist, und Seitenflächen (200c, 200c'), die die Vorder- und Rückseiten der photovoltaischen Teilzelle verbinden, umfasst, wobei wenigstens eine (200c') der Seitenflächen jeder photovoltaischen, bezeichnet als zusätzlichen Teilzelle (200), aus dem Zuschneiden einer photovoltaischen Zelle resultiert;
- Abdecken (S2) einer Passivierungsschicht (210) wenigstens einer zusätzlichen Seitenfläche (200c') der photovoltaischen Teilzellen per Einhalten eines Passivierungsverfahrens gemäß irgendeinem der Ansprüche 1 bis 8.

11. Herstellungsverfahren gemäß Anspruch 10, bei dem das Zuschneiden jeder photovoltaischen Zelle (100) einen Kontaktschritt (F1) einer der Vorder- und Rückseiten (100a, 100b) der photovoltaischen Zelle mit einem Laser (130) zum Bilden eines Grabens (140) und einen mechanischen Spaltungsschritt (F2) der photovoltaischen Zelle (100) ab dem Graben (140) umfasst.

12. Herstellungsschritt gemäß Anspruch 11, bei dem die Passivierungsschicht (210) darüber hinaus wenigstens ein Band (200d) der von dem Laser (130) kontaktierten Seite abdeckt, wobei das genannte wenigstens eine Band an der genannten wenigstens einen zusätzlichen Seitenfläche (200c') angrenzt und weniger als 5 % der Fläche der vom Laser kontaktierten Seite darstellt.

13. Herstellungsverfahren gemäß irgendeinem der Ansprüche 10 bis 12, bei dem die photovoltaischen Zellen (100) in halbe Zellen (200) oder in Teileinheiten mit einer Fläche von weniger als der einer halben Zelle zugeschnitten werden.

## Claims

1. Method for passivating photovoltaic cells (200) each comprising a front face (200a) intended for being exposed to incident radiation, a back face (200b) opposite to the front face, and side surfaces (200c, 200c') connecting the front face and the back face, the method being **characterized in that** it comprises the following steps:
- forming a group of photovoltaic cells (200, 201, 202);
- forming a passivation layer (210) by spatial atomic layer deposition simultaneously on several of the photovoltaic cells of the group, such that the passivation layer covers at least one (200c') of the side surfaces of each photovoltaic cell (200, 201, 202), less than 5% of the surface area of the front face (200a) of each photovoltaic cell and less than 5% of the surface area of the back face (200b) of each photovoltaic cell.

2. Passivation method according to claim 1, wherein the group of photovoltaic cells comprises first and second photovoltaic cells (201, 202) spaced apart from each other and resting on one of their front and back faces (200a, 200b), one (200c') of the side surfaces of the first photovoltaic cell (201) facing one of the side surfaces (200c') of the second photovoltaic cell (202).

3. Passivation method according to claim 2, wherein the passivation layer (210) is deposited simultaneously on the first and second photovoltaic cells (201, 202) by means of a gas distribution head (300), the gas distribution head comprising a gas outlet surface (320) with a width (I) greater than or equal to the distance (d) separating the first and second photovoltaic cells (201, 202).

4. Passivation method according to claim 1, wherein the group of photovoltaic cells comprises a plurality of photovoltaic cells (200) stacked on one another.

5. Passivation method according to claim 4, wherein the photovoltaic cells (200) of the group form a single stack (500) and rest on one of their side surfaces (200c, 200c') or on one of their front and back faces (200a, 200b).

6. Passivation method according to claim 5, wherein the passivation layer (210) is formed simultaneously on all the photovoltaic cells (200) of the group by means of a gas distribution head (300), the gas distribution head (300) comprising a gas outlet surface (320) with a width (I) equal to or greater than the height (h) of the stack (500).

7. Passivation method according to claim 4, wherein the photovoltaic cells (200) of the group form two stacks (501, 502) arranged facing each other and rest on one of their front and back faces (200a, 200b).

8. Passivation method according to claim 7, wherein the passivation layer (210) is formed simultaneously on all the photovoltaic cells (200) of the group by means of a gas distribution head (600), the gas distribution head (600) being positioned between the two stacks (501, 502) and comprising two opposite gas outlet surfaces (321, 322) with a width (I) greater than or equal to the height (h) of each stack.

9. Passivation method according to one of claims 1 to 8, wherein the passivation layer (210) is formed of alumina (Al₂O₃), silicon dioxide (SiO₂), silicon nitride (Si₃N₄) or hydrogenated amorphous silicon nitride (a-SiₓN_{y}:H)).

10. Method for manufacturing passivated photovoltaic sub-cells (200), comprising the following steps of:
- providing photovoltaic cells (100) each comprising a front face (100a) intended for being exposed to incident radiation and a back face (100b) opposite to the front face;
- cutting (S1) the photovoltaic cells (100) to form a plurality of photovoltaic sub-cells (200), each photovoltaic sub-cell comprising a front face (200a) intended for being exposed to incident radiation, a back face (200b) opposite to the front face and side surfaces (200c, 200c') connecting the front and back faces of the photovoltaic sub-cell, at least one (200c') of the side surfaces of each photovoltaic sub-cell (200), referred to as an additional side surface, resulting from cutting a photovoltaic cell (100);
- covering (S2) with a passivation layer (210) at least one additional side surface (200c') of the photovoltaic sub-cells, in accordance with a passivation method according to any of claims 1 to 8.

11. Manufacturing method according to claim 10, wherein cutting each photovoltaic cell (100) comprises a step (F1) of exposing one of the front and back faces (100a, 100b) of the photovoltaic cell to a laser (130) to form a trench (140) and a step (F2) of mechanically cleaving the photovoltaic cell (100) from the trench (140).

12. Manufacturing method according to claim 11, wherein the passivation layer (210) further covers at least one strip (200d) of the face exposed to laser (130), said at least one strip being contiguous with said at least one additional side surface (200c') and accounting for less than 5% of the surface area of the face exposed to laser.

13. Manufacturing method according to any of claims 10 to 12, wherein the photovoltaic cells (100) are cut into half-cells (200) or sub-units with a surface area less than that of a half-cell.
